Europäisches Patentamt

European Patent Office

Office européen des brevets

(11) Numéro de publication: **0 324 679**
**A2**

## DEMANDE DE BREVET EUROPEEN

(21) Numéro de dépôt: **89400068.6**

(51) Int. Cl.⁴: **G 01 D 5/20**

(22) Date de dépôt: **10.01.89**

(30) Priorité: **12.01.88 FR 8800261**

(43) Date de publication de la demande:
**19.07.89 Bulletin 89/29**

(84) Etats contractants désignés:
**AT BE CH DE ES GB GR IT LI LU NL SE**

(71) Demandeur: **RADIO CONTROLE S.A.**
**13, rue Clément Boyer**
**F-69000 Lyon (Rhone) (FR)**

(72) Inventeur: **Palencher, Jacques**
**26 Rue Général Saussier**
**Troyes (Aube) (FR)**

(74) Mandataire: **Cabinet Pierre HERRBURGER**
**115, Boulevard Haussmann**
**F-75008 Paris (FR)**

(54) **Appareil de mesure ferromagnétique.**

(57) Appareil de mesure ferromagnétique comportant un axe (17) sur lequel est fixée une aiguille (4) se déplaçant devant un cadran (7) et d'une première palette métallique (22), cet axe étant monté à pivotement, sur des paliers d'extrémité, à l'intérieur d'un logement d'un corps de bobine (1) pour se déplacer par rapport à une seconde palette métallique (23) fixée à l'intérieur de ce logement, l'un des paliers (9) d'extrémité étant prévu à l'une des extrémités du logement du corps de bobine (1), l'autre palier (13) étant prévu sur une raquette (6) s'assemblant de manière amovible sur le corps de bobine, à l'autre extrémité du logement, un ressort spiral (14) étant en outre prévu en liaison avec l'axe de l'aiguille, appareil de mesure caractérisé en ce que le ressort spiral (14) est fixé par son extrémité centrale à la raquette et par son extrémité extérieure à l'axe (17) solidaire de l'aiguille (4)

FIG.1

EP 0 324 679 A2

# Description

## Appareil de mesure ferromagnétique

L'invention concerne un appareil de mesure ferromagnétique.

La présente invention a pour but la réalisation d'un appareil de mesure de ce type, qui soit d'une construction et d'un montage rapides, simples et peu onéreux, tout en aboutissant à la réalisation d'un appareil de bonne sensibilité et de bonne précision.

Les appareils connus de ce genre comportent, en effet, un très grand nombre de pièces qui sont fabriquées indépendamment les unes des autres et qui doivent ensuite être assemblées pour réaliser des sous-ensembles, ces sous-ensembles étant ensuite montés les uns sur les autres pour réaliser l'appareil de mesure.

Suivant la présente invention, il est ainsi prévu de réaliser un groupement particulier de ces différentes pièces, afin de constituer des sous-ensembles permettant une réalisation simple en une seule pièce, par moulage d'une matière plastique. Le nombre de pièces ou de sous-ensembles ainsi réalisés pourront alors être rapidement et simplement assemblés les uns sur les autres sans outillage particulier, afin de réaliser l'appareil de mesure.

La présente invention concerne un appareil de mesure ferromagnétique comportant un axe sur lequel est fixée une aiguille se déplaçant devant un cadran et d'une première palette métallique, cet axe étant monté à pivotement, sur des paliers d'extrémité, à l'intérieur d'un logement d'un corps de bobine pour se déplacer par rapport à une seconde palette métallique fixée à l'intérieur de ce logement, l'un des paliers d'extrémité étant prévu à l'une des extrémités du logement du corps de bobine, l'autre palier étant prévu sur une raquette s'assemblant de manière amovible sur le corps de bobine, à l'autre extrémité du logement, un ressort spiral étant en outre prévu en liaison avec l'axe de l'aiguille, appareil de mesure caractérisé en ce que le ressort spiral est fixé par son extrémité centrale à la raquette et par son extrémité extérieure à l'axe solidaire de l'aiguille.

Suivant une autre caractéristique de l'invention, la raquette présente une portée axiale formant un palier pour le pivotement de l'une des extrémités de l'axe, cette portée axiale constituant le support de l'extrémité centrale du spiral.

Suivant une autre caractéristique de l'invention, l'extrémité extérieure du spiral est fixée sur l'aiguille.

L'invention est représentée à titre d'exemple non limitatif sur les dessins ci-joints dans lesquels :

- la figure 1 est une vue en coupe axiale partielle de l'appareil conforme à l'invention,
- la figure 2 est une vue de dessus de la figure 1,
- la figure 3 est une vue de dessus de la raquette,
- la figure 4 est une vue de dessus de l'équipage mobile de l'appareil,
- la figure 5 est une vue de dessus du corps de bobine.

L'appareil représenté sur les dessins se compose d'un corps de bobine 1 sur lequel est formé le bobinage de l'appareil ferromagnétique. Le fût 2 de ce corps est réalisé creux et reçoit l'équipage mobile 3 portant l'aiguille indicatrice 4. Cet équipage mobile est monté à pivotement, d'une part sur le fond 5 du fût creux 2, d'autre part sur une raquette 6 montée à pivotement sur le corps 2 de la bobine. Cet appareil est complété par un cadran 7 et par une glace transparente 8.

Le corps 1 de la bobine, avec son fût 2, est réalisé par moulage d'une matière plastique et forme une seule pièce avec le fond 5 de la partie creuse du fût 2 et ce fond 5 comporte, venue de moulage, la crapaudine 9 recevant à pivotement une extrémité de l'équipage mobile 3.

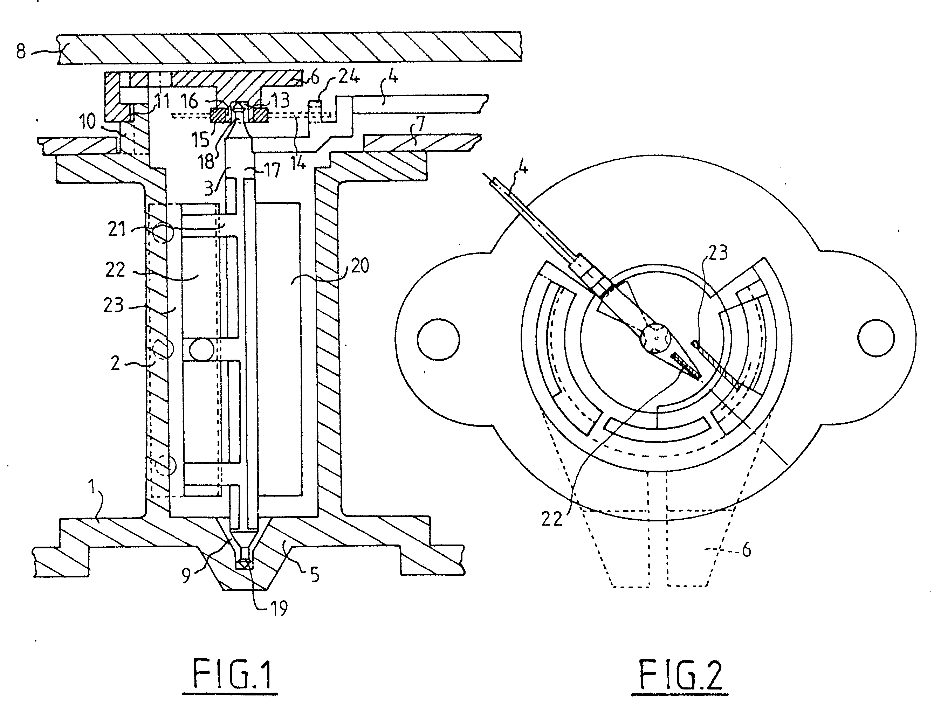

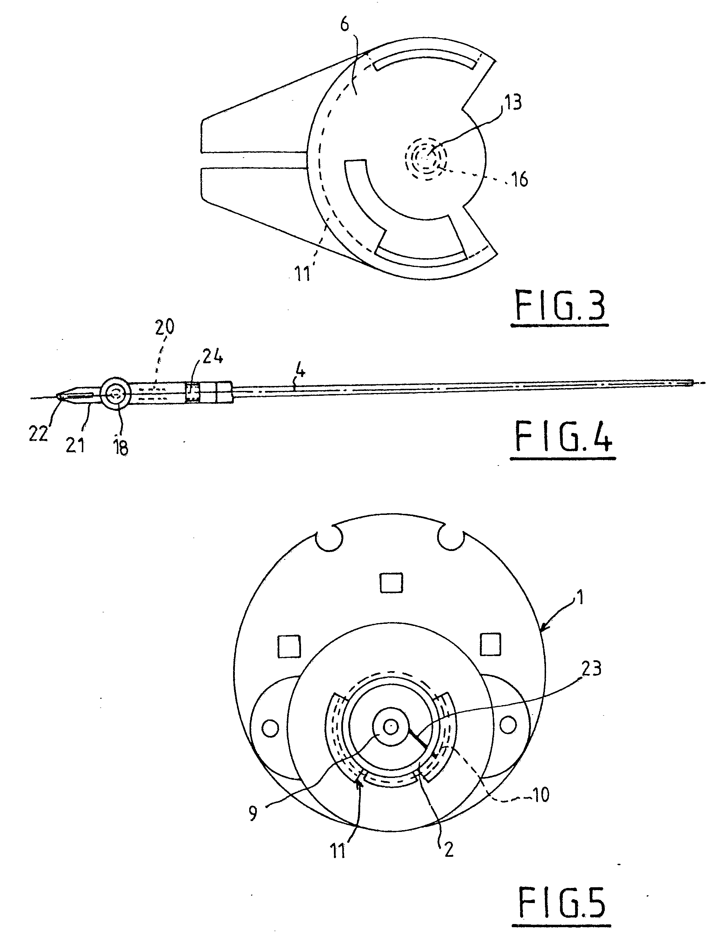

L'extrémité opposée du fût 2 présente un prolongement 10 également venu de moulage avec le corps de bobine, ce prolongement 10 étant de forme circulaire et comportant des secteurs évidés afin de pouvoir recevoir à pivotement, dans une rainure 11, la raquette 6. La raquette 6 (voir notamment figures 1 et 3) est pourvue d'un rebord intérieur circulaire 12 qui est également partiellement découpé afin de permettre la mise en place de la raquette 6 sur le corps de bobine 1, tout d'abord par un déplacement axial en décalant angulairement les découpes du rebord 12 et les découpes du prolongement 10 puis, ensuite, par un mouvement de rotation d'un quart de tour qui fait pénétrer le rebord 12 dans la rainure 11.

Cette raquette 6 est également réalisée en une seule pièce par moulage d'une matière plastique et comporte, venue de moulage, la crapaudine 13 recevant à pivotement la partie supérieure de l'équipage mobile 3.

Le ressort spiral 14 de l'appareil, est monté, par son extrémité intérieure, sur une virole 15 qui vient se fixer par emboîtement sur une portée correspondante formée sur la raquette 6 et entourant la crapaudine 13.

L'équipage mobile 3 est réalisé également en une seule pièce par moulage d'une matière plastique, et comporte un axe 17 se terminant par les pointes de pivotage supérieur 18 et inférieur 19, cet axe étant réalisé en une seule pièce avec l'aiguille indicatrice 4 et avec une palette d'amortissement 20 disposée radialement parallèlement à l'axe 17.

L'axe 17 comporte également des pattes 21 qui maintiennent la palette métallique 22 de l'équipage mobile, cette palette étant destinée à coopérer avec la palette 23 prévue à l'intérieur du fût 2 du corps de bobine, afin d'assurer le déplacement de l'équipage mobile en fonction de la grandeur du courant électrique parcourant la bobine.

Les palettes 22 et 23 seront, de préférence, fixées sur les pattes 21 de l'équipage mobile 3, ainsi qu'à l'intérieur du fût 2 du corps de bobine 1 par surmoulage, afin de les positionner directement lors de la réalisation, par moulage, de ces deux pièces.

La palette 20, orientée radialement, est également destinée à coopérer avec la palette 23 du fût de la bobine, afin de constituer un organe d'amortissement par compression de l'air entre ces palettes 20 et 23 lorsque l'équipage mobile 3 pivote brusquement et que cette palette 20 se rapproche de la palette 23.

Cette palette en matière plastique 23, obtenue directement par moulage de l'équipage mobile 3, est également de dimensions et de position déterminées, afin de contrebalancer le poids de la palette métallique mobile 22 pour permettre la réalisation d'un équipage mobile équilibré.

L'aiguille 4 de cet équipage mobile 3 est pourvue d'un plot 24 orienté parallèlement à l'axe 17. L'extrémité extérieure du ressort spiral 14 est pourvue d'une boucle dont le diamètre correspond à celui de ce plot 24 de façon que l'extrémité extérieure du ressort spiral 14 puisse être reliée à l'aiguille 4 simplement en plaçant cette boucle sur le plot 24 qui est situé dans le plan du ressort spiral 14. De préférence, l'extrémité libre de ce plot 24 est pourvue d'une zone de diamètre élargie afin de retenir la boucle du ressort.

On constate que l'appareil de mesure ferromagnétique conforme à l'invention se compose essentiellement de trois pièces obtenues par moulage d'une matière plastique, la première de ces pièces formant le corps de bobine 1 avec l'une des crapaudines recevant à pivotement l'équipage mobile, la deuxième pièce formant la raquette s'adaptant à pivotement sur le corps de bobine et recevant le ressort spiral 14 afin de former avec un sous-ensemble, la troisième pièce étant constituée par l'équipage mobile 3 formant en une seule pièce l'axe de pivotement 17 avec les pointes de pivotage, l'aiguille 4 et la palette d'amortissement et d'équilibrage 20.

Lors du montage de l'appareil, il suffit donc d'introduire l'équipage mobile dans la partie creuse du fût 2 du corps de bobine et de mettre en place la raquette 6 pourvue du spiral 14, l'extrémité extérieure du spiral pouvant alors être rapidement mise en place sur le plot 24.

## Revendications

1) Appareil de mesure ferromagnétique comportant un axe (17) sur lequel est fixée une aiguille (4) se déplaçant devant un cadran (7) et d'une première palette métallique (22), cet axe étant monté à pivotement, sur des paliers d'extrémité, à l'intérieur d'un logement d'un corps de bobine (1) pour se déplacer par rapport à une seconde palette métallique (23) fixée à l'intérieur de ce logement, l'un des paliers (9) d'extrémité étant prévu à l'une des extrémités du logement du corps de bobine (1), l'autre palier (13) étant prévu sur une raquette (6) s'assemblant de manière amovible sur le corps de bobine, à l'autre extrémité du logement, un ressort spiral (14) étant en outre prévu en liaison avec l'axe de l'aiguille, appareil de mesure caractérisé en ce que le ressort spiral (14) est fixé par son extrémité centrale à la raquette et par son extrémité extérieure à l'axe (17) solidaire de l'aiguille (4).

2) Appareil conforme à la revendication 1, caractérisé en ce que la raquette (6) présente une portée axiale (16) formant un palier (13) pour le pivotement de l'une des extrémités de l'axe, cette portée axiale constituant le support de l'extrémité centrale du spiral (14).

3) Appareil conforme à l'une quelconque des revendications précédentes, caractérisé en ce que l'extrémité extérieure du spiral (14) est fixée sur l'aiguille (4).

4) Appareil conforme à l'une quelconque des revendications précédentes, caractérisé en ce que l'aiguille (4) et son axe (17) sont réalisés en une seule pièce avec un contre-poids (20) équilibrant le poids de la palette métallique (22) de cet équipage mobile.

5) Appareil conforme à la revendication 4, carac térisé en ce que le contre-poids est réalisé sous la forme d'une palette radiale (20) coopérant avec la palette métallique fixe (23) du corps de bobine (1) pour former un organe d'amortissement.

FIG.2

FIG.1

_FIG.3_

_FIG.4_

_FIG.5_